(19) Europäisches Patentamt

European Patent Office

Office européen des brevets

(11) **EP 1 675 338 A1**

(12) **DEMANDE DE BREVET EUROPEEN**

(43) Date de publication:
**28.06.2006 Bulletin 2006/26**

(51) Int Cl.:
*H04L 25/06* (2006.01)    *H03K 5/08* (2006.01)

(21) Numéro de dépôt: **05112393.3**

(22) Date de dépôt: **19.12.2005**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **23.12.2004 FR 0453202**

(71) Demandeur: **ALCATEL**
**75008 Paris (FR)**

(72) Inventeurs:
- **Bisson, Arnaud**
  **Résidence d'Orsay**
  **91400 Orsay (FR)**
- **Ait Sab, Omar**
  **91290 Arpajon (FR)**

(54) **Dispositif de conversion analogique-numérique avec circuit de décision et seuil de décision optimisé**

(57)     Le dispositif comporte un circuit de décision (6a) pour fournir, par comparaison de l'amplitude d'un signal modulé reçu (Sr) à un seuil de décision (Vth, Th), un signal binaire (Sb) à deux états représentatifs respectivement de première et seconde valeurs binaires qui correspondent respectivement à des niveaux bas et haut du signal reçu.

Un module de comptage (12) activé pendant des intervalles de temps successifs calcule une valeur numérique différentielle (DN, SDN) représentative de la différence algébrique entre les deux nombres d'informations binaires portées par le signal binaire qui ont respectivement la seconde et la première valeur binaire.

A la fin de chaque intervalle de temps, un module d'ajustement (15) augmente ou diminue la valeur de seuil (Vth, Th) d'un incrément (Dth) selon que le signe (SDN) de la différence est respectivment positif ou négatif.

Application notamment aux systèmes de transmission de données numériques à haut débit par liaisons optiques.

FIG_2

EP 1 675 338 A1

**Description**

L'invention se situe dans le domaine des systèmes de télécommunication pour la transmission de données numériques. Elle concerne plus particulièrement les techniques de réception de signaux numériques à haut débit, transmis par exemple par des liaisons à longue distance utilisant des fibres optiques.

Un système de transmission comporte typiquement au moins un émetteur relié à un récepteur par l'intermédiaire d'une liaison qui, dans le cas d'un système optique peut être constituée d'une simple fibre et/ou d'un milieu de couplage plus complexe comportant par exemple des amplificateurs optiques et des commutateurs réalisés au moyen de coupleurs, de guides et de portes optiques.

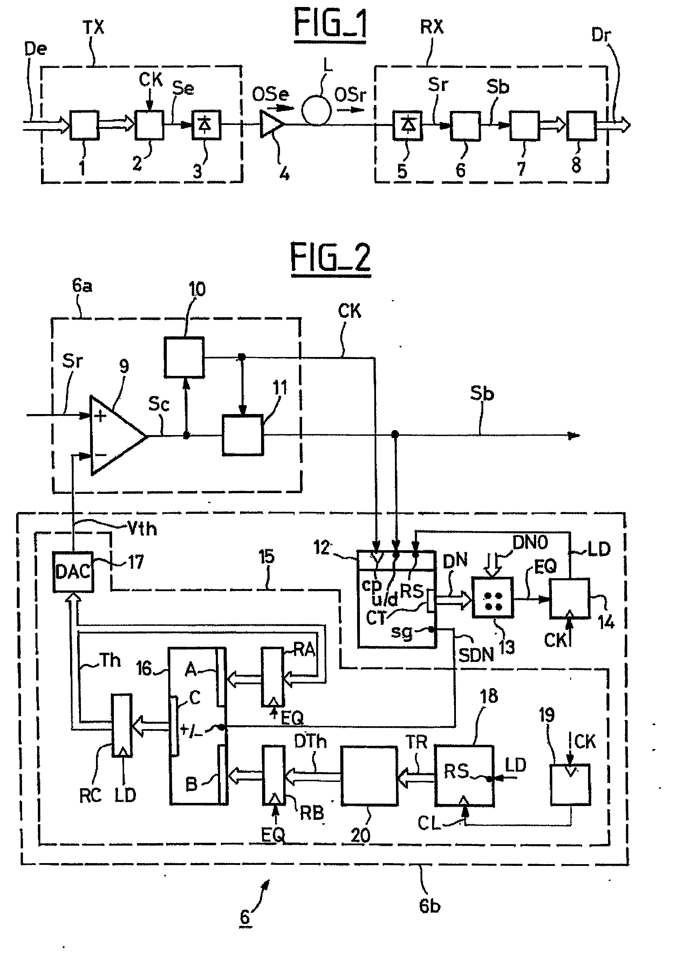

Un exemple de système de transmission est montré schématiquement sur la figure 1. Un émetteur optique TX est couplé à une extrémité d'une liaison optique L, ici par l'intermédiaire d'un amplificateur optique 4, pour y injecter un signal optique OSe. L'autre extrémité de la liaison, couplée à un récepteur optique RX, lui délivre un signal optique OSr résultant de la transmission du signal émis OSe.

Selon un schéma classique, les informations à transmettre sont fournies à l'émetteur TX par une station (non représentée) et se présentent généralement sous la forme de données numériques De organisées, par informations binaires successives. Elles sont appliquées à une interface d'entrée parallèle de l'émetteur. A partir de cette interface, l'émetteur comporte une chaîne de traitement comprenant successivement un module de transcodage 1, un convertisseur parallèle-série 2 et un convertisseur électro-optique 3. Ces éléments permettent de coder et convertir les données numériques De en un signal binaire série Se sous la forme d'un signal électrique modulé, puis de le convertir en un signal optique OSe par modulation d'une onde porteuse optique en fonction du signal électrique Se.

Pour en plus mettre en oeuvre le multiplexage en longueur d'onde, le système sera muni d'un multiplexeur (non représenté) disposé entre lé convertisseur 3 et l'amplificateur 4 permettant de combiner plusieurs signaux portés par des longueurs d'onde différentes et issus de plusieurs émetteurs. Dans ce cas, il faudra aussi prévoir un démultiplexeur (non représenté) disposé entre l'extrémité de réception de la liaison et chaque récepteur.

Le récepteur RX comporte une chaîne de traitement comprenant successivement un convertisseur optoélectronique 5 recevant le signal optique OSr et fournissant un signal électrique modulé Sr; un convertisseur analogique-numérique 6 pour former à partir du signal Sr un signal binaire série Sb, un convertisseur série-parallèle 7 et un décodeur 8 pour fournir les données numériques reçues Dr correspondant aux données numériques émises De.

Le convertisseur parallèle-série 2 de l'émetteur crée un signal électrique modulé Se au rythme d'une horloge d'émission CK de façon à inscrire des informations binaires dans des intervalles de temps successifs ayant chacun une durée égale à la période de l'horloge. La fréquence de l'horloge d'émission (aussi appelée fréquence bit) détermine le débit binaire de la transmission.

Le signal électrique Se est obtenu par modulation d'amplitude d'une grandeur électrique (typiquement la tension) selon un des formats de modulation classiques, généralement de type NRZ ou RZ. Le signal Se porte ainsi des informations binaires successives sous la forme d'une modulation entre des niveaux bas et hauts d'amplitude représentatifs respectivement de première et seconde valeurs d'information binaire, selon une convention habituelle désignées ici par "0" et "1" respectivement.

La conversion du signal Se en un signal optique OSe consiste à appliquer à l'onde porteuse une modulation, généralement de son amplitude, mais pouvant s'exercer sur sa phase ou sa fréquence optique, ou encore sur une combinaison de ces grandeurs physiques.

Le convertisseur optoélectronique 5 du récepteur RX sera alors adapté au type de modulation choisi pour l'émission, de façon à fournir un signal électrique Sr modulé en amplitude qui reproduit le signal électrique émis Se. Comme le signal émis Se, le signal reçu Sr porte des informations binaires successives sous la forme d'une modulation entre des niveaux bas et hauts d'amplitude représentatifs respectivement des valeurs binaires 0 et 1, d'après notre convention.

Le dispositif 6 pour convertir le signal reçu Sr en un signal numérique série doit mettre en oeuvre deux fonctions principales : une récupération du rythme d'horloge d'émission CK à partir du signal reçu Sr, et une comparaison de l'amplitude du signal reçu Sr à un niveau de seuil de décision, cette comparaison étant prise en compte pendant des fenêtres d'échantillonnage synchronisées par .le rythme d'horloge récupéré et calées en phase par rapport au signal. En fonction de cette comparaison, on obtient un signal binaire série Sb, c'est-à-dire un signal modulé en rythme avec l'horloge CK, et pouvant prendre pendant chaque temps bit un premier ou un second état discret, ces deux états (typiquement des premier et second niveaux de tension fixés) étant représentatifs respectivement des niveaux bas et hauts d'amplitude du signal reçu Sr, c'est-à-dire, d'après notre convention, représentant respectivement la première et la seconde valeur binaire 0 et 1.

Au moyen de l'horloge récupérée, le signal binaire Sb peut ensuite être traité par des circuits numériques classiques disposés en aval dans le récepteur (notamment le convertisseur série-parallèle 7 et le décodeur 8).

Les fonctions de récupération du rythme d'horloge et de comparaison sont effectuées par un circuit habituellement appelé "circuit de décision" dans lequel la valeur attribuée au niveau de seuil de décision est un paramètre critique pour reconnaître correctement les valeurs binaires successives reçues après transmission. Dans les cas favorables (sources d'émission stables et calibrées, courtes distances de transmission, faible débit, faible bruit optique, faibles dégradations apportées par la liaison optique), cette valeur peut être fixe, généralement choisie sensiblement égale à la moyenne des niveaux bas et hauts du signal reçu Sr.

Si par contre ces niveaux bas et hauts sont susceptibles de fluctuer fortement, par exemple selon la source ayant émis le signal, ou en fonction du chemin qu'il a suivi dans le réseau, ou encore suite à des variations de bruit optique ou à des déformations du signal dues à des effets non linéaires, le dispositif 6 devra comporter des moyens d'asservissement pour compenser automatiquement les fluctuations.

Pour cela, on peut agir sur le signal reçu Sr, avant comparaison, par une amplification associée à un système de contrôle automatique de gain qui ajuste à un niveau constant l'amplitude moyenne (ou composante continue) du signal., Ce système est par exemple un circuit analogique de type filtre intégrateur qui reçoit en entrée le signal Sr et fournit en sortie une commande de gain appliquée à un amplificateur à gain ajustable.

Une autre solution peut consister au contraire à asservir par un circuit analogue au précédent le niveau de seuil à une valeur optimale tenant compte de l'amplitude moyenne du signal reçu Sr.

L'inconvénient de ces méthodes est que le circuit analogique est difficile à réaliser pour obtenir une précision de réglage suffisante. De plus, il faut optimiser son dimensionnement en termes de bande passante et de constantes de temps en fonction du débit binaire, ce qui ne facilite pas les mises à niveaux par augmentation de débit d'un système installé.

Selon une autre approche, on peut exploiter le fait que les systèmes de transmission de données numériques appliquent souvent des méthodes de détection et de correction d'erreurs (ou "FEC" pour "Forward Error Correction" en anglais) qui permettent de calculer en temps réel le taux d'erreur affectant les données reçues. De façon classique, on utilise pour cela des codes détecteurs et correcteurs d'erreurs, et l'émetteur calcule en fonction du code choisi et des données d'information De à émettre des données redondantes qui sont ensuite émises avec les données d'information. Ces données redondantes sont calculées par blocs successifs de données d'information et associées à celles-ci pour former des trames émises successivement.

Les données de chaque trame reçue par le récepteur sont traitées par un module de détection et de correction d'erreurs pour calculer des syndromes d'erreurs représentatifs des emplacements d'éventuelles erreurs détectées et les corriger. Ce module fournit d'autres indications telles que le nombre d'erreurs détectées, le taux d'erreurs etc. Le calcul des données redondantes sera effectué par exemple au niveau du module de transcodage 1 représenté à la figure 1. Le traitement des syndromes d'erreurs sera effectué par exemple au niveau du décodeur 8.

Dans ce contexte, on peut ajuster automatiquement le niveau de seuil en recherchant comme valeur optimale celle qui permet de minimiser le taux d'erreurs. Une mise en oeuvre peut consister à utiliser un algorithme d'optimisation utilisant comme paramètre à minimiser les valeurs successives du taux d'erreurs mesuré pour les trames successives reçues. Cette méthode peut toutefois se révéler décevante car il arrive que l'algorithme converge vers des minima locaux du taux d'erreurs qui ne correspondent donc pas à la valeur de seuil optimale.

Selon l'invention, on va exploiter une propriété générale des transmissions binaires selon laquelle statistiquement les nombres de 0 et de 1 émis sont sensiblement égaux. Cette approche est particulièrement adaptée pour de nombreux systèmes de transmission qui appliquent avant émission un embrouillage ("scrambling" en anglais) des données binaires et un désembrouillage correspondant en réception.

L'embrouillage, effectué par exemple au niveau du module de transcodage 1 représenté à la figure 1, vise à ce que les données binaires émises soient telles que les signaux électriques et optiques modulés émis et donc reçus qui en résultent possèdent des propriétés particulières qui facilitent leur traitement par le récepteur.

Une de ces propriétés est le fait que dans toute séquence de données composée d'un nombre minimal de bits prédéfini, le nombre de 0 doit rester voisin du nombre de 1. On assure ainsi que sur tout intervalle de temps au moins égal à la durée de transmission correspondant à ce nombre minimal de bits le signal transmis présente une valeur moyenne indépendante de l'information transmise. Un autre exemple de propriété visant à faciliter la récupération du rythme d'horloge est le fait que les séqueriees de 0 consécutifs et de 1 consécutifs ont des durées limitées.

Compte tenu de ces observations, l'invention propose une méthode nouvelle pour déterminer le niveau de seuil de décision qui permette d'éviter les inconvénients des autres solutions exposées ci-dessus.

Dans ce but, l'invention a pour objet un dispositif de conversion en un signal numérique d'un signal reçu modulé au rythme d'une horloge et portant des informations binaires successives sous la forme d'une modulation entre des niveaux bas et hauts d'amplitude, ledit dispositif comportant :

-  un circuit de décision pour fournir, en fonction d'une comparaison de l'amplitude dudit signal reçu à un niveau de seuil de décision, un signal binaire ayant un premier ou un second état selon que ladite amplitude est inférieure ou supérieure audit niveau de seuil de décision, lesdits premier et second états étant associés respectivement à des première et seconde valeurs d'information binaire,
-  un circuit d'asservissement prévu pour ajuster la valeur, dite valeur de seuil, dudit niveau de seuil de décision, ledit dispositif de conversion étant caractérisé en ce que ledit circuit d'asservissement comprend :

- un premier module de comptage apte à calculer une valeur numérique différentielle représentative de la différence algébrique entre les deux nombres d'informations binaires portées par le signal binaire et qui ont respectivement ladite seconde valeur binaire et ladite première valeur binaire, ce module de comptage fournissant une indication du signe de ladite différence,
- un module de commande du premier module de comptage pour définir les durées d'intervalles de temps successifs durant lesquels ledit calcul de valeur numérique différentielle est effectué,
- un, module d'ajustement conçu pour augmenter ou diminuer à la fin de chaque intervalle de temps ladite valeur de seuil d'une valeur d'incrément selon que ladite indication de signe correspond respectivement à un signe positif ou négatif.

Selon un mode de réalisation conforme à l'invention particulièrement simple à mettre en oeuvre ledit module de commande est disposé pour recevoir ladite valeur numérique différentielle et définit la fin d'un intervalle de temps à l'instant où la valeur absolue de cette valeur numérique différentielle calculée depuis le début de cet intervalle de temps atteint une valeur limite, cet instant définissant aussi Le début d'un intervalle de temps suivant.

Selon une variante qui permet d' augmenter la rapidité de l'ajustement tout en évitant une instabilité de la valeur de seuil au voisinage de sa valeur optimale, ledit module d'ajustement est conçu pour ajuster ladite valeur d'incrément selon une fonction décroissante de ladite durée des intervalles de temps successifs.

Selon un autre aspect de réalisation ledit module d'ajustement comprend un circuit de chronométrage comportant une source d'impulsions d'horloge et un second module de comptage disposé pour compter les impulsions produites par ladite source pendant chacun desdits intervalles de temps successifs.

Avantageusement, ladite source produit lesdites impulsions d'horloge avec une fréquence sous-multiple ,de la fréquence d'horloge rythmant la modulation du signal reçu.

L'invention a également pour objet un récepteur pour système de transmission comportant un dispositif de conversion tel que défini ci-dessus.

L'invention concerne enfin un système de transmission comportant un tel récepteur.

D'autres, aspects et avantages de l'invention apparaîtront dans la suite de la description en référence aux figures.

- La figure 1 représente le système de transmission déjà commenté précédemment.
- La figure 2 représente' un exemple de réalisation d'un dispositif de conversion selon l'invention.
- La figure 3 comporte des chronogrammes montrant des exemples de signal reçu permettant d'expliquer le principe de l'invention.
- La figure 4 est un chronogramme qui montre un exemple d'évolution au cours du temps de la valeur d'incrément de la valeur de seuil, selon une variante de l'invention.

La figure 2 montre schématiquement et à titre d'exemple un dispositif de conversion 6 selon l'invention et pouvant faire partie du récepteur RX du système de transmission présenté à la figure 1.

Le dispositif 6 est formé d'un circuit de décision 6a associé à un circuit d'asservissement 6b. Le circuit de décision 6a, d'un type courant, comporte essentiellement un comparateur 9 recevant sur une première entrée le signal Sr issu du convertisseur optoélectronique 5 et sur une seconde entrée la valeur de seuil Vth fournie par le circuit d'asservissement 6b. La sortie du comparateur 9 est reliée d'une part à un circuit 10 de récupération du signal d'horloge CK et d'autre part à un circuit d'échantillonnage et de mise en forme 11.

De façon classique, le comparateur 9 fournit un signal de comparaison Sc pouvant présenter un premier ou un second niveau selon que l'amplitude du signal Sr est inférieure ou supérieure à la valeur de seuil Vth.

Grâce aux transitions présentes dans le signal Sc, le circuit 10 est apte à créer un signal d'horloge récupéré CK, c'est-à-dire un signal périodique ayant la fréquence bit et en relation de phase avec le signal Sc. En réponse au signal d'horloge CK et au signal de comparaison Sc, le circuit 11 peut alors fournir un signal binaire Sb calibré au format voulu.

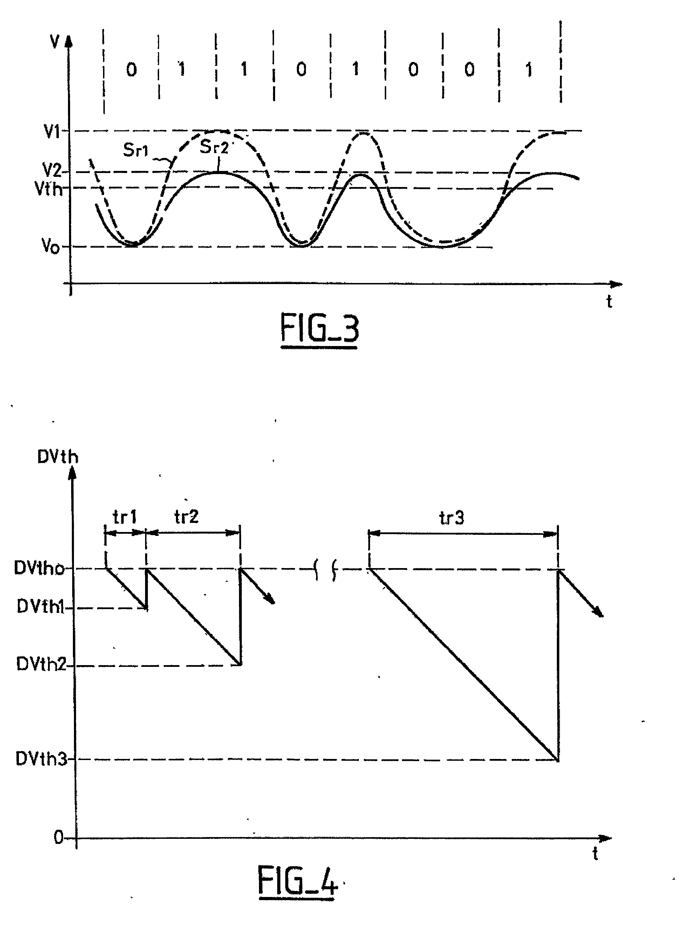

Le circuit d'asservissement 6b conforme à l'invention est prévu pour ajuster la valeur de seuil Vth de la façon qui va être exposée ci-dessous. Il convient auparavant d'expliquer le principe de l'invention à l'aide des chronogrammes de la figure 3.

Les chronogramme montrent respectivement les variations en fonction du temps de l'amplitude V de deux exemple Sr1 et Sr2 de signal Sr portant la même séquence binaire 0 1 1 0 1 0 0 1.

Le signal Sr1 représenté par un tracé en tirets correspond au cas idéal où la valeur de seuil Vth est bien ajustée, c'est-à-dire sensiblement égale à la moyenne des niveaux minima V0 et maxima V1 de l'amplitude du signal. Le signal Sr2, représenté par un tracé en trait plein, correspond par contre à un cas défavorable où le niveau maximal V2 étant plus faible, la même valeur de seuil Vth est supérieure à cette moyenne.

On voit que la comparaison de l'amplitude de Sr1 avec la valeur de seuil Vth va permettre au comparateur 9 de fournir aisément un signal de comparaison Sc dont les niveaux bas ou hauts successifs correspondent bien à la séquence binaire. Il en sera de même pour le signal binaire Sb en résultant.

Par contre pour le signal Sr2, compte tenu des bruits en amplitude et en phase (non représentés), il est probable qu'une où plusieurs données binaires ayant la valeur "1" à l'émission soient reconnues en réception comme ayant la valeur "0", Les mêmes erreurs vont aussi se retrouver dans le signal binaire Sb.

Avec l'hypothèse qu'en l'absence d'erreurs toute "longue" séquence binaire du signal devrait comporter sensiblement le même nombre de "0" que de "1", on peut dire que sur un intervalle de temps donné suffisant (ou une séquence binaire de longueur donnée suffisante), la différence algébrique ADN entre les nombres N1 et N0 d'informations binaires portées par le signal binaire Sb et ayant respectivement les valeurs "1" et "0" constitue une estimation de l'écart entre la valeur de seuil Vth effective et une valeur de seuil optimale. Cette estimation fait abstraction des autres causes d'erreurs, mais leurs contributions sont a priori aléatoires et les erreurs en résultant devraient statistiquement porter de façon égale sur les valeurs "1" et "0", ce qui serait donc sans effet sur la différence ADN.

Ainsi, la valeur absolue DN de la différence ADN = N1-N0 peut être interprétée comme le double du nombre total de bits en erreur à cause d'une valeur de seuil incorrecte dans une séquence binaire comportant N1+NO bits. De plus, ADN positif indique un excès de "1" donc, avec notre convention, que le seuil est trop bas. Inversement, ADN négatif indique que le seuil est trop haut. Le signé SDN de ADN indique donc dans quel sens il convient de corriger la valeur de seuil Vth pour la rapprocher de sa valeur optimale. Le rapport ER = DN/2(N1+N2) donne une indication de l'écart entre les valeurs actuelle et optimale du seuil. On peut noter que ce rapport ER est analogue à un taux d'erreur binaire pour la séquence considérée et peut prendre des valeurs inférieures ou égales à 1/2.

On pourrait donc envisager un asservissement qui ajuste la valeur de seuil Vth en fonction de ER qui serait calculé périodiquement.

L'invention propose toutefois une méthode différente qui permet une mise en oeuvre plus simple et un asservissement plus rapide. Plus précisément, elle consiste à définir des intervalles de temps successifs et, durant chacun de ces intervalles de temps, on calcule par comptage la valeur numérique différentielle représentative de la différence algébrique ADN entre les nombres N1 et N0 d'informations binaires portées par le signal binaire Sb ayant respectivement la seconde valeur binaire ("1") et la première valeur binaire ("0") . Ce calcul fournit en particulier une indication du signe SDN de cette différence algébrique ADN.

Ensuite, à la fin de chaque intervalle de temps, on augmente ou on diminue la valeur de seuil Vth d'une valeur d'incrément DVth (grandeur positive) selon que l'indication de signe SDN correspond respectivement à un signe positif ou négatif.

Avantageusement, la détermination des intervalles de temps successifs peut s'effectuer simplement de la façon suivante. On se donne d'abord une valeur limite DN0 de la valeur absolue DN de la différence algébrique ADN. On définit alors la fin d'un intervalle de temps pendant lequel un calcul est en cours à l'instant où la valeur absolue DN de la différence algébrique ADN calculée depuis le début de cet intervalle de temps atteint la valeur limite DN0 prédéfinie. Cet instant définit alors aussi le début de l'intervalle de temps suivant.

L'avantage de cette méthode est que chaque intervalle de temps définit une durée de comptage tr qui est d'autant plus courte qu'un nombre d'erreurs fixé à DN0 est atteint rapidement.

En effet, si DR est le débit binaire pour le signal Sb, l'intervalle de temps pour que DN atteigne DNO est donné par :

$$tr = (N0+N1)/DR \qquad (1),$$

et avec ER = DN/(N1+N2) et DN = DN0, on obtient:

$$tr = DN0/(ER.DR) \qquad (2).$$

La vitesse dVth/dt de variation (en valeur absolue) du seuil Vth sera alors donné par:

$$dVth/dt = DVth/tr = DVth.ER.DR/DN0 \qquad (3).$$

Dans le cas le plus simple, on peut choisir une valeur d'incrément DVth qui est constante. D'après (3), on voit que la vitesse dVth/dt de variation du seuil est alors proportionnelle au rapport ER, ce qui implique que l'asservissement présente un temps de réponse côurt car l'ajustement est d'autant plus rapide que la valeur de seuil Vth est éloignée de sa valeur optimale.

Dans une variante visant à améliorer la stabilité de l'asservissement lorsque la valeur de seuil Vth est proche de sa valeur optimale, la valeur d'incrément DVth est ajustée selon une fonction décroissante de la durée tr. On peut par exemple faire varier DVth selon une fonction linéaire décroissante de tr. On aura alors :

$$\text{DVth} = \text{Max}(0, \text{DVth0}-\text{k1.tr}) \qquad (4),$$

où DVth0 et k1 sont des constantes, et :

$$\text{dVth/dt} = \text{DVth/tr} = \text{Max}(0, \text{DVth0.ER.DR/DN0}-\text{k1}) \quad (5).$$

Ainsi, la présence du coefficient k1 permet de maintenir Vth à une valeur stable lorsque ER atteint la valeur limite qui annule DVth donc dVth/dt. La valeur du coefficient k1 sera déterminée par le choix de cette valeur limite qui correspond à une valeur de ER qu'on estime inutile de chercher à diminuer davantage.

Selon un cas particulier, on peut utiliser une source produisant des impulsions d'horloge avec une fréquence proportionnelle à la fréquence d'horloge CK (avantageusement sous-multiple pour des raisons de coût) rythmant la modulation du signal reçu Sr. Dans ce cas :

$$\text{DVth} = \text{Max}(0, \text{DVth0}-\text{k2.tr.DR}) \qquad (6),$$

où k2 est une constante, et :

$$\text{dVth/dt} = \text{DVth/tr} = \text{Max}(0, \text{DVth0.ER.DR/DN0}-\text{k2.DR}) \quad (7).$$

On voit dans ce cas que la vitesse de variation du seuil dVth/dt reste proportionnelle au débit binaire DR, ce qui implique un temps de réponse de l'asservissement inversement proportionnel au débit dans un rapport qui est indépendant du débit. Il en résulte des performances en terme de précision indépendantes du débit.

Le chronogramme de la figure 4 illustre ces deux derniers cas. Il montre l'évolution de durées successives tr1-tr3 de comptage d'impulsions d'horloge pour que DN atteigne DN0 lorsque la valeur de seuil Vth converge progressivement vers la valeur de seuil optimale. En ordonnées sont représentées les différentes valeurs DVth1-DVth3 de DVth qui en résultent respectivement.

Après ces explications sur le procédé d'asservissement selon l'invention, nous pouvons revenir à sa mise en oeuvre pratique par le circuit d'asservissement 6b de la figure 2.

Le circuit d'asservissement 6b comprend un premier module de comptage 12 associé à un module d'ajustement de seuil 15.

Le premier module de comptage 12 essentiellement constitué d'un compteur- décompteur de type classique comportant une entrée de comptage cp, une entrée de sélection de comptage ou de décomptage u/d, une entrée RS de remise à 0 du compteur, une sortie parallèle CT délivrant en nombre binaire la valeur absolue de l'état du compteur et une sortie sg fournissant un signal indicatif du signe SDN de cet état du compteur.

Les deux entrées cp et u/d reçoivent respectivement le signal d'horloge récupéré CK et le signal binaire Sb.

Un comparateur numérique 13 a une première entrée reliée à la sortie parallèle du module 12, une seconde entrée recevant le nombre binaire DN0 et une sortie fournissant un signal EQ actif lorsque le nombre binaire reçu par sa première entrée est au moins égal à DN0. Le signal EQ est ensuite appliqué à une bascule 14 de synchronisation commandée par le signal d'horloge CK. Le signal LD fourni par la bascule est appliqué sur l'entrée RS de remise à 0.

Compte tenu des signaux appliqués sur les entrées du module 12, on voit que selon la valeur binaire 1 ou 0 présente dans le signal Sb, son état de comptage augmente ou diminue d'une unité à chaque période d'horloge correspondante. Ainsi, après une remise à 0 du module 12, celui-ci contient un compte égal à la différence algébrique entre les nombres de 1 et de 0 portés par le signal binaire depuis l'instant de cette une remise à 0, c'est-à-dire la valeur algébrique ADN composée de sa valeur absolue DN présente sur la sortie parallèle CT et de son signe SDN présent sur la sortie de signe sg.

Lorsque DN atteint DN0 le signal EQ change d'état et le signal LD devient actif à la période d'horloge suivante, ce qui provoque une remise à 0 du module 12. Les éléments 13 et 14 constituent donc pour le module de comptage 12 un module de commande qui définit les durées tr des intervalles de temps successifs durant lesquels le calcul de ADN est effectué.

Le module d'ajustement de seuil 15 comporte un circuit additionneur/soustracteur 16 muni de deux entrées parallèles A et B, d'une sortie parallèle C et d'une entrée de commande d'addition ou soustraction +/-. L'entrée A est reliée à la sortie d'un registre RA commandé par le signal EQ. La sortie C est reliée à un autre registre RC commandé par le signal LD. La sortie du registre RC est reliée d'une part à l'entrée d'un convertisseur numérique-analogique 17 et d'autre part à l'entrée du registre RA. L'entrée de commande +/- reçoit le signal indicatif du signe SDN. Le convertisseur 17 fournit en sortie la valeur de seuil Vth appliquée au comparateur 9.

L'entrée B est prévue pour recevoir une valeur numérique DTh représentative de la valeur d'incrément DVth. Celle-ci peut être fixe où au contraire ajustable. La réalisation décrite ici correspond à ce dernier cas. Pour cela, l'entrée B est reliée à la sortie d'un troisième registre RB commandé par le signal BQ. Le registre RB est prévu pour être chargé par la valeur numérique DTh fournie par les éléments 18 à 20 qui seront détaillés plus loin.

Le registre RC est prévu pour contenir une valeur numérique Th représentative de la dernière valeur de seuil Vth à utiliser. Le registre RA est prévu pour contenir la valeur numérique Th représentative de la précédente valeur de seuil Vth.

Ainsi, lorsque DN atteint DN0, le signal EQ change d'état et provoque le chargement dans les registres RA et RB respectivement de la valeur de Th représentative de la dernière valeur de seuil et la valeur numérique DTh représentative de la valeur d'incrément Dvth.

Selon que le signe SDN est positif ou négatif à cet instant, le circuit 16 est commandé pour fonctionner en additionneur ou en soustracteur et fournit sur sa sortie C comme nouvelle valeur de Th la précédente valeur respectivement augmentée ou diminuée de DTh. Cette nouvelle valeur de Th est alors chargée dans le registre RC en réponse à l'activation du signal LD à la période d'horloge suivante.

Le dispositif de la figure 2 met aussi en oeuvre la variante de l'invention qui prévoit d'ajuster la valeur d'incrément DVth selon une fonction positive décroissante de la durée tr durant laquelle le calcul de ADN est effectué.

Pour cela, il est prévu un circuit de chronométrage constitué d'une source 19 d'impulsions d'horloge CL et d'un second module de comptage 18 disposé pour compter les impulsions produites par la source 19. Le module 18 comporte une entrée de remise à 0 recevant le signal LD et une sortie parallèle reliée à une entrée d'un transcodeur numérique 20 servant de table de conversion numérique.

Ainsi, au moment où la nouvelle valeur de Th est chargée dans le registre RC en réponse à l'activation du signal LD, le second module de comptage 18 est remis à 0. Il compte ensuite les impulsions CL produites par la source 19. Son état évolue donc depuis cette remise à 0 pour prendre des valeurs de comptage proportionnelles au temps écoulé, ces valeurs étant appliquées à l'entrée du transcodeur 20.

L'instant où DN atteint DN0 définit la fin de l'intervalle de temps durant lequel le calcul de ADN est effectué. A cet instant, le signal EQ change d'état, le module de comptage 18 présente en sortie une valeur de comptage TR proportionnelle à la durée tr de cet intervalle de temps et le transcodeur numérique 20 délivre en sortie la valeur numérique DTh représentative de la nouvelle valeur d'incrément DVth. Le changement d'état du signal EQ provoque alors le chargement dans le registre RB de cette nouvelle valeur numérique d'incrément DTh.

Le transcodeur numérique 20 peut être programmé pour appliquer au nombre binaire qu'il reçoit en entrée, c'est-à-dire TR, une fonction numérique choisie, par exemple une fonction linéaire de la forme DTh = DTh0-K1. TR tant que cette expression reste positive, cette fonction restant égale à 0 dans le cas contraire.

Les impulsions d'horloge CL sont produites par la source 19 à une fréquence constante qui peut être très inférieure à la fréquence bit du signal. La fréquence d'horloge CL peut aussi être choisie égale à un sous-multiple de la fréquence bit dans un rapport fixe indépendant de la fréquence bit. On peut réaliser ce dernier cas en utilisant comme source 19 un diviseur de fréquence recevant en entrée le signal d'horloge CK.

Pour la réalisation pratique, on devra choisir une valeur de DNO. Ce choix n'est pas très critique et pourra dépendre essentiellement du temps de réponse que l'on souhaite pour l'asservissement, et du débit.. Par exemple, une valeur de l'ordre de 100 conviendra dans la plupart des cas usuels.

Pour la variante de l'invention où la valeur d'incrément DVth est ajustable, on définira aussi les pas de variation minimal et maximal applicables à l'incrément. On pourra les définir en pourcentages de la plage d'excursion prévue pour les valeurs de seuil Vth, et les, choisir égaux par exemple à 1 % et 20% respectivement.

Les choix précédents permettent alors de dimensionner en conséquence les différents composants numériques du circuit d'asservissement 6b.

Bien entendu, l'invention n'est pas limitée au mode de réalisation qui vient d'être décrit. En particulier, les circuits numériques peuvent être remplacés par un dispositif de traitement numérique programmé pour effectuer des fonctions analogues.

## Revendications

**1.** Dispositif de conversion (6) en un signal numérique d'un signal reçu (Sr) modulé au rythme d'une horloge (CK) et portant des informations binaires successives sous la forme d'une modulation entre des niveaux bas et hauts d'amplitude, ledit dispositif comportant :

- un circuit de décision (6a) pour fournir, en fonction d'une comparaison de l'amplitude (V) dudit signal reçu (Sr) à un niveau de seuil de décision, un signal binaire (Sb) ayant un premier ou un second état selon que ladite amplitude est inférieure ou supérieure audit niveau de seuil de décision, lesdits premier et second états étant associés respectivement à des première et seconde valeurs d'information binaire,
- un circuit d'asservissement (6b) prévu pour ajuster la valeur, dite valeur de seuil (Vth, Th), dudit niveau de seuil de décision,

ledit dispositif de conversion étant **caractérisé en ce que** ledit circuit d'asservissement (6b) comprend :

- un premier module de comptage (12) apte à calculer une valeur numérique différentielle représentative de la différence algébrique (ADN) entre les deux nombres (N1, N0) d'informations binaires portées par le signal binaire et qui ont respectivement ladite seconde valeur binaire et ladite première valeur binaire, ce module de comptage fournissant une indication du signe (SDN) de ladite différence,
- un module de commande (13, 14) du premier module de comptage (12) pour définir les durées (TR, tr1-tr3)) d'intervalles de temps successifs durant lesquels ledit calcul de valeur numérique différentielle est effectué,
- un module d'ajustement (15) conçu pour augmenter ou diminuer à la fin de chaque intervalle de temps ladite valeur de seuil (Vth, Th) d'une valeur d'incrément (DTh) selon que ladite indication de signe (SDN) correspond respectivement à un signe positif ou négatif.

**2.** Dispositif selon la revendication 1, **caractérisé en ce que** ledit module de commande (13, 14) est disposé pour recevoir ladite valeur numérique différentielle (ADN) et définit la fin d'un intervalle de temps à l'instant où la valeur absolue (DN) de cette valeur numérique différentielle calculée depuis le début de cet intervalle de temps atteint une valeur limite (DN0), cet instant définissant aussi le début d'un intervalle de temps suivant.

**3.** Dispositif selon la revendication 2, **caractérisé en ce que** ledit module d'ajustement (15) est conçu pour ajuster ladite valeur d'incrément (DTh) selon une fonction décroissante de ladite durée (TR) des intervalles, de temps successifs.

**4.** Dispositif selon la revendication 3, **caractérisé en ce que** ledit module d'ajustement (15) comprend un circuit de chronométrage (18, 19) comportant une source (19) d'impulsions d'horloge (CL) et un second module de comptage (18) disposé pour compter les impulsions produites par ladite source pendant chacun desdits intervalles de temps successifs.

**5.** Dispositif selon la revendication 4, **caractérisé en ce que** ladite source (19) produit lesdites impulsions d'horloge avec une fréquence sous-multiple de la fréquence d'horloge (CK) rythmant la modulation du signal reçu (Sr).

**6.** Récepteur (RX) pour système de transmission, **caractérisé en ce qu'**il comporte un dispositif de conversion (6) selon l'une des revendications 1 à 5.

**7.** Système de transmission comportant au moins un émetteur (TX) relié à un récepteur (RX) par l'intermédiaire d'une liaison (L), **caractérisé en ce que** ledit récepteur (RX) est conforme à la revendications 6.

EP 1 675 338 A1

## FIG_1

## FIG_2

9

FIG_3

FIG_4

<table>
<tr><td colspan="2"><strong>Office européen<br>des brevets</strong></td><td><strong>RAPPORT DE RECHERCHE EUROPEENNE</strong></td><td>Numéro de la demande<br>EP 05 11 2393</td></tr>
</table>

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 0 531 549 A (MATSUSHITA ELECTRIC INDUSTRIAL CO., LTD) 17 mars 1993 (1993-03-17) * figures 1,3,4 * | 1,2,6,7 | INV. H04L25/06 H03K5/08 |
| A | * colonne 3 - colonne 6 * ----- | 3-5 | |
| X | WO 92/14322 A (COGNITO GROUP LIMITED) 20 août 1992 (1992-08-20) | 1,2,6,7 | |
| A | * pages 7-9; figure 3 * ----- | 3-5 | |

**DOMAINES TECHNIQUES RECHERCHES (IPC)**

H04L
H03K
H04N

Le présent rapport a été établi pour toutes les revendications

| Lieu de la recherche | Date d'achèvement de la recherche | Examinateur |
|---|---|---|
| Berlin | 25 avril 2006 | Fouasnon, O |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 05 11 2393

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-04-2006

| Document brevet cité au rapport de recherche | | Date de publication | Membre(s) de la famille de brevet(s) | | Date de publication |
|---|---|---|---|---|---|
| EP 0531549 | A | 17-03-1993 | DE<br>DE<br>WO<br>US | 69222106 D1<br>69222106 T2<br>9217029 A1<br>5469091 A | 16-10-1997<br>15-01-1998<br>01-10-1992<br>21-11-1995 |
| WO 9214322 | A | 20-08-1992 | AU<br>NZ | 1197392 A<br>241490 A | 07-09-1992<br>28-08-1995 |

EPO FORM P0460

Pour tout renseignement concernant cette annexe : voir Journal Officiel de l'Office européen des brevets, No.12/82